# EUROPÄISCHE PATENTANMELDUNG

(11) **EP 1 229 773 A2**
(43) Veröffentlichungstag der Anmeldung: **07.08.2002**
(21) Anmeldenummer: 01129579.7
(22) Anmeldetag: 12.12.2001
(51) Int. Cl.: H05K 7/14

(54) **Passiver Verteiler zum Verbinden von elektrischen Geräten wie Aktoren und/oder Sensoren**

(30) Priorität: 05.02.2001 DE 20102038 U
(71) Anmelder: Weidmüller Interface GmbH & Co., 32760 Detmold (DE)
(72) Erfinder: Frikkee, Arian, 32760 Detmold (DE)
(74) Vertreter: Specht, Peter, Dipl.-Phys.

(57) **Zusammenfassung**

Ein passiver Verteiler zum Verbinden von Aktoren und/oder Sensoren (S1, S2) mit wenigstens einem elektrischen Gerät, insbesondere mit einer Steuerungseinheit wie einem PC oder einer SPS, wobei der Verteiler folgendes aufweist: wenigstens einen ersten Anschlußbereich (4) zum Anschluß der Aktoren und/oder Sensoren an den Verteiler (2), und einen zweiten Anschlußbereich, der vorzugsweise an den ersten Anschlußbereich (4) angrenzt und der zum Anschluß wenigstens eines Anschlußkabels (8) für die Versorgung der Aktoren und/oder Sensoren und/oder zur Weiterleitung der Aktor-/Sensorsignale- insbesondere Logikinformationen - zwischen den Aktoren/Sensoren und dem externen elektrischen Gerät vorgesehen ist, zeichnet sich dadurch aus, daß eine Elektronikschaltung (24) zur Vorverarbeitung, insbesondere zur Verknüpfung der von den Sensoren (S1, S2) eingehenden Daten vor deren Weiterleitung zum externen elektrischen Gerät (SPS, PC) ist.

## Beschreibung

Die Erfindung betrifft einen passiven Verteiler zum Verbinden von Aktoren und/oder Sensoren mit wenigstens einem elektrischen Gerät, insbesondere mit einer Steuerungseinheit wie einem PC oder einer SPS, wobei der Verteiler folgendes aufweist:
- wenigstens einen ersten Anschlußbereich zum Anschluß der Aktoren und/oder Sensoren an den Verteiler und
- einen zweiten Anschlußbereich, der vorzugsweise an den ersten Anschlußbereich angrenzt und der zum Anschluß wenigstens eines Anschlußkabels für die Versorgung der Aktoren und/oder Sensoren und/oder zur Weiterleitung der Aktor-/Sensorsignale- insbesondere Logikinformationen - zwischen den Aktoren/Sensoren und dem externen elektrischen Gerät vorgesehen ist.

Ein Verteiler der gattungsgemäßen Art ist beispielsweise aus der EP 0 909 121 oder auch aus dem deutschen Gebrauchsmuster DE 299 09 204 bekannt.

Derartige Verteiler weisen eine Mehrzahl an Steckplätzen auf. Bewährt hat sich insbesondere eine Formgebung mit einem relativ flachen Gehäuse mit z.B. vier, sechs oder acht Anschlüssen bzw. Steckplätzen (z.B. M 12) für den Anschluß der Sensoren und Aktoren.

Die Buchsen der Anschlüsse sind in der Regel über eine Leiterplatte parallel mit z.B. zwei Steckverbinderleisten verbunden, die in einem Anschlußgehäuse angeordnet sind. Von hier aus erfolgt die Weiterleitung der Sensordaten z.B. an den PC oder an die SPS.

Je nach Anzahl der Sensoren werden bei passiven Verteilern also von den Steckverbinderleisten z.B. vier, sechs oder acht Leitungen an die weiterverarbeitende SPS geführt. Dies erfordert dann z.B. auch die Belegung von vier, sechs oder acht Eingängen. Derartige Eingänge sind relativ teuer. Derzeit betragen die Kosten für einen einzigen Eingang oftmals bis zu 30,- DM.

Die Erfindung beschäftigt sich daher mit der Aufgabe, die nötige Anzahl von Verbindungsleitungen sowie die Anzahl von an der Steuerungseinheit zu belegenden Eingängen zu reduzieren.

Die Erfindung löst diese Aufgabe durch den Gegenstand des Anspruches 1.

Danach weist der passive Verteiler eine Elektronikschaltung zur Vorverarbeitung, insbesondere zur Verknüpfung der von den Sensoren eingehenden Daten vor deren Weiterleitung zum externen elektrischen Gerät auf.

Es ist damit nur noch ein einziges Steuerungssignal bzw. eine einzige Leitung vom passiven Verteiler zur Steuerungseinheit nötig, d.h. der Verdrahtungsaufwand wird deutlich verringert. Es muß auch nur noch ein einziger Eingang an der Steuerungseinheit belegt werden. U.U. kann sogar die Zykluszeit in der Steuerungseinheit beim Verarbeiten der Signale verringert werden.

Nach einer weiteren Ausführungsform weist die (Zusatz-)Elektronikschaltung Bauelemente zur logischen Verknüpfung der Sensorsignale (z.B. AND, NAND, NOR ...) auf, welche die von dem elektrischen Gerät kommenden Signale in einfacher Weise logisch vorverarbeiten verknüpfen und das verknüpfte Signal an die Steuerungseinheit weiterleiten.

Der Vorteil dieser Variante der Erfindung sei ergänzend auch an einem kurzen Beispiel erläutert. Angenommen, es werden an einer Maschine die Stellungen verschiedener Schalter überwacht, z.B. die Schalter von Lichtschranken oder ähnlichen Sicherungssystemen. Die Ausgangssignale der Schalter werden sodann über den passiven Verteiler und die Elektronikschaltung logisch miteinander verknüpft, so daß dann, wenn nur einer der Schalter in einen unvorhergesehenen Schaltzustand schaltet, durch die Verknüpfung der Signale eine Weitergabe dieser Information an die Steuerungseinheit nicht erfolgt. Insbesondere eignet sich die Erfindung für die Verarbeitung von Sensorsignalen. Erst dann, wenn alle mit der Elektronikschaltung vorgegebenen Bedingungen erfüllt sind, erfolgt von der Elektronikschaltung aus die Weitergabe an die Steuerungseinheit.

Nach einem weiteren Ausführungsbeispiel ist die Elektronikschaltung steckbar ausgebildet, vorzugsweise auf einer Leiterplatte. Als besonderer Vorteil zu nennen ist hier die Möglichkeit, die Elektronikschaltung nachrüstbar auszugestalten. Auf diese Weise können auch nachträglich noch passive Verteiler mit einer Elektronikschaltung zur Vorverarbeitung der Sensorsignale versehen werden.

Zusammengefaßt ist festzustellen, daß mit der Erfindung die Anzahl der nötigen Verbindungsleitungen vom Verteiler zur Steuerungseinheit und die Anzahl der an der Steuerungseinheit zu belegenden Eingänge deutlich reduziert wird.

Vorzugsweise ist die Leiterplatte platzsparend und praktisch handhabbar in einem Gehäuse des Verteilers angeordnet.

Nachfolgend wird ein Ausführungsbeispiel unter Bezug auf die Zeichnung näher beschrieben. Es zeigt:
- Figur 1: eine Sprengansicht eines erfindungsgemäßen passiven Verteilers;
- Figur 2: eine schematische Ansicht eines passiven Verteilers nebst daran angeschlossenen Sensoren und der an den Verteiler angeschlossenen Steuerungseinheit.

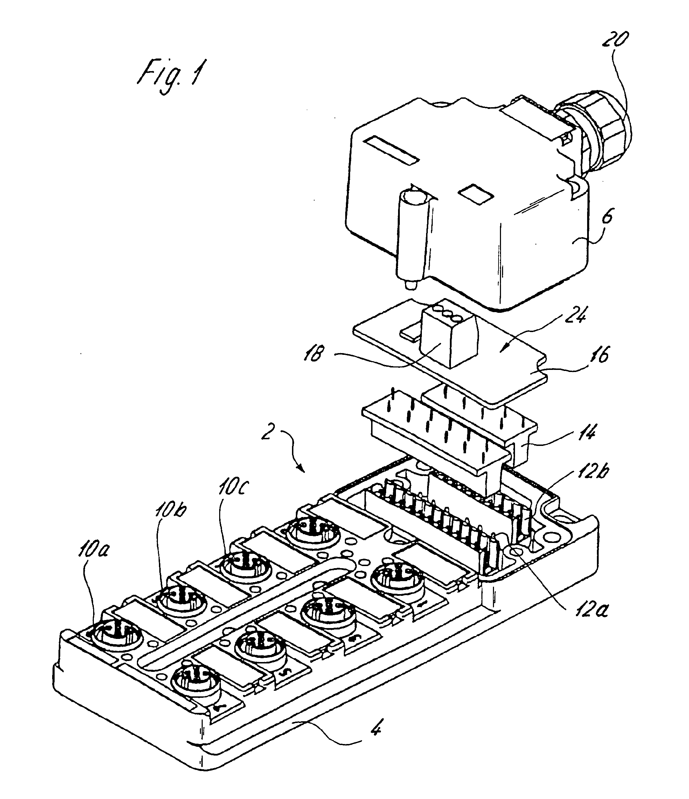

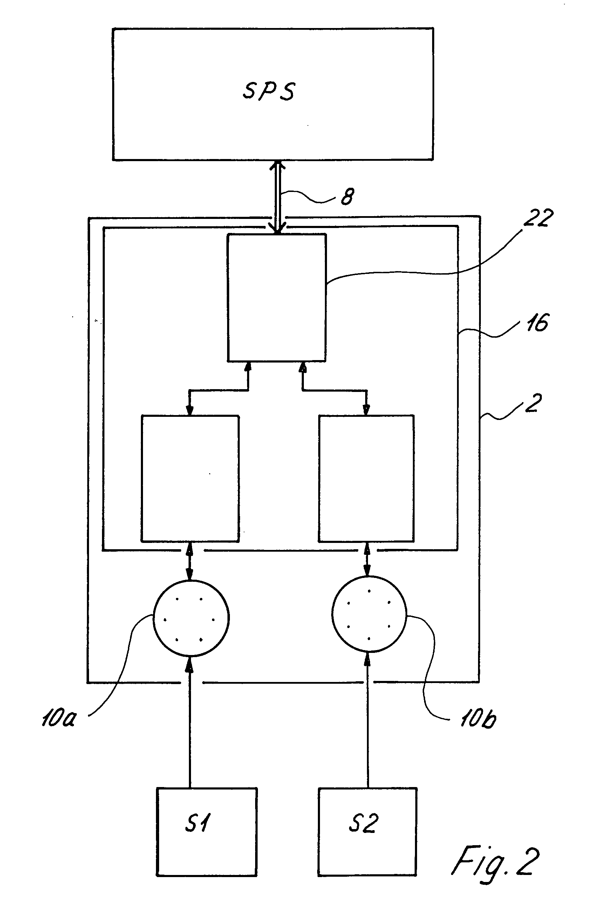

Figur 1 zeigt einen Verteiler 2 zum Verbinden von Aktoren und/oder Sensoren S1, S2 (siehe Fig. 2) mit wenigstens einem externen elektrischen Gerät. Dieses externe Gerät kann beispielsweise eine Steuerungseinheit wie ein PC oder eine SPS sein.

Der Verteiler 2 weist einen Anschlußblock 4 ausgebildeten Anschlußbereich zum Anschluß der Aktoren und/oder Sensoren an dem Verteiler 2 auf sowie ein an den Anschlußblock 4 ansetzbares Anschlußgehäuse 6 als Anschlußbereich zum Anschluß wenigstens eines Anschlußkabels 8 für die Versorgung der Aktoren und/oder Sensoren oder zur Weiterleitung der Aktor-/Sensorsignale zwischen der SPS und dem Verteiler 2 auf.

Auf dem Anschlußblock sind zwei Reihen von je z.B. vier Anschlüssen 10a, 10b, ... für die Aktoren oder Sensoren angeordnet. Die Anschlüsse 10 sind mit zwei Anschlußleisten 12 im Anschlußgehäuse 6 verbunden. Direkt auf diese Anschlußleisten oder indirekt über zwischengeschaltete Steckerleisten 14 kann eine Leiterplatte 16 kontaktiert werden, die mit (siehe Fig. 2) Logikbausteinen 22 versehen ist, die zu einer Elektronikschaltung 24 zur Vorverarbeitung der von den Aktoren und/oder Sensoren kommenden Signale zusammengefaßt sind. Von der Leiterplatte 16 sind über das Anschlußelement 18 nur noch wenige Datenleitungen durch die Öffnung 20 des Anschlußgehäuses 6 zur SPS zu führen. In Abhängigkeit von der zu lösenden logischen Aufgabe können verschiedene Leiterplatten 16 mit entsprechenden Bauelementen bereitgestellt werden.

Ein besonderer Vorteil dieser Ausbildung der Erfindung ist noch darin zu sehen, daß die Leiterplatte 16 mit der Elektronikschaltung 24 leicht auswechselbar steckbar ausgebildet ist und daß handelsübliche passive Verteiler je nach Anforderung mit beliebigen maßgeschneiderten Zusatzschaltungen nachträglich vor Ort oder kurz vor der Auslieferung nachgerüstet werden können.

### Bezugszeichen

- Verteiler: 2
- Anschlußblock: 4
- Anschlußgehäuse: 6
- Anschlußkabel: 8
- Anschlüsse: 10a, 10b, ...
- Anschlußleisten: 12a, 12b
- Steckerleisten: 14
- Leiterplatte: 16
- Anschlußelement: 18
- Öffnung: 20
- Logikbausteine: 22
- Elektronikschaltung: 24
- Sensoren: S1, S2

## Patentansprüche

1. Passiver Verteiler zum Verbinden von Aktoren und/oder Sensoren (S1, S2) mit wenigstens einem elektrischen Gerät, insbesondere mit einer Steuerungseinheit wie einem PC oder einer SPS, wobei der Verteiler folgendes aufweist:
- wenigstens einen ersten Anschlußbereich (4) zum Anschluß der Aktoren und/oder Sensoren an den Verteiler (2), und
- einen zweiten Anschlußbereich, der vorzugsweise an den ersten Anschlußbereich (4) angrenzt und der zum Anschluß wenigstens eines Anschlußkabels (8) für die Versorgung der Aktoren und/oder Sensoren und/oder zur Weiterleitung der Aktor-/Sensorsignale- insbesondere Logikinformationen - zwischen den Aktoren/Sensoren und dem externen elektrischen Gerät vorgesehen ist,
**gekennzeichnet durch**
- eine Elektronikschaltung (24) zur Vorverarbeitung, insbesondere zur Verknüpfung der von den Sensoren (S1, S2) eingehenden Daten vor deren Weiterleitung zum externen elektrischen Gerät (SPS, PC).

2. Verteiler nach Anspruch 1, **dadurch gekennzeichnet, daß** die Elektronikschaltung (24) steckbar ausgebildet ist.

3. Verteiler nach Anspruch 1 oder 2, **dadurch gekennzeichnet, daß** die Elektronikschaltung (24) Bauelemente (22) zur logischen Verknüpfung der Sensorsignale aufweist.

4. Verteiler nach einem der vorstehenden Ansprüche, **dadurch gekennzeichnet, daß** die Elektronikschaltung (24) auf einer Leiterplatte (16) angeordnet ist.

5. Verteiler nach einem der vorstehenden Ansprüche, **dadurch gekennzeichnet, daß** die Leiterplatte (6) in einem Gehäuse (6) des Verteilers angeordnet ist.
